# EUROPÄISCHE PATENTSCHRIFT

(11) **EP 0 903 969 B1**
(45) Veröffentlichungstag und Bekanntmachung des Hinweises auf die Patenterteilung: **10.03.2004**
(21) Anmeldenummer: 98116589.7
(22) Anmeldetag: 02.09.1998
(51) Int. Cl.: H05K 3/36, H05K 1/11, H05K 1/00

(54) **Elektronische Baugruppe**
Electronic printed circuit board
Circuit imprimé électronique

(30) Priorität: 18.09.1997 DE 19741047
(43) Veröffentlichungstag der Anmeldung: 24.03.1999
(73) Patentinhaber: Conti Temic microelectronic GmbH, 90411 Nürnberg (DE); Marquardt GmbH, 78604 Rietheim-Weilheim (DE)
(72) Erfinder: Seitz, Georg, 85092 Kasing (DE); Wolfschläger, Roland, 91154 Roth (DE); Lach, Joachim, 86633 Neuburg (DE); Sachs, Ekkehard, 78549 Spaichingen (DE); Klein, Ernst-Ludwig, 85101 Lenting (DE)

(56) Entgegenhaltungen:
- US-A- 4 958 260
- US-A- 5 093 985
- PATENT ABSTRACTS OF JAPAN vol. 13, no. 113 (E-729), 17. März 1989 (1989-03-17) & JP 63 284896 A (FUJITSU), 22. November 1988 (1988-11-22)
- PATENT ABSTRACTS OF JAPAN vol. 13, no. 280 (E-779), 27. Juni 1989 (1989-06-27) & JP 01 066991 A (CANON), 13. März 1989 (1989-03-13)

## Beschreibung

Die Erfindung betrifft eine elektronische Baugruppe gemäß dem Oberbegriff des Patentanspruchs 1.

Aus der der US 5,093,985 ist bereits ein Herstellungsverfahren für kleine elektrische Geräte und Baugruppen bekannt, bei dem eine räumliche Leiterplattenanordnung mit flexiblen Folienverbindern zum Einsatz kommt.

Flexible Folienverbinder ermöglichen es dabei, mehrere einzelne Leiterplattenstücke elektrisch zu verbinden und entsprechend den räumlichen Anforderungen anzuordnen. Flexible Folienverbinder sind dem Stand der Technik ebenfalls bereits bekannt. So können bekanntermaßen sogenannte Flachkabel, also mehrere Kupferlitzeleitungen nebeneinander in einer Kunststoffummantelung zur flexiblen Verbindung von Leiterplatten verwendet werden, wie dies beispielsweise zwischen PC-Karten üblich ist. Flexible Verbindungskabel für Leiterplatten sind auch aus der Schrift US 4,268,956 bekannt, ebenso eine Vorrichtung zum Verbinden von auf Folien aufgebrachten elektrischen Leitbahnen gemäß der Gebrauchsmusteranmeldung DE-GM 7717962. Derartige Formen von Folienverbindern sind zwar sehr flexibel, können aber keine definierte Lagefixierung der Leiterplattenstücke gewährleisten. Aus diesem Grunde weist auch die Erfindung in der Druckschrift US 5,093,985 zusätzlich mechanische Halterungen auf, die als Einrastmittel zwischen den unterschiedlichen Leiterplattenstücken ausgestaltet sind. Ähnliche flexible Verbinder für Leiterplattenstücke sind auch aus der Druckschrift JP 5-90749 oder der JP 6-112622 bekannt. Auch diese erfordern eine zusätzliche Halterung der Leiterplattenstücke. Des weiteren weist die US 5,274,195 einen flexiblen Leiterplattenverbinder und insbesondere ein Verfahren zu dessen Herstellung auf, bei dem die Flachleiterbahnen abgeätzt werden. Der Leiterplattenverbinder wird dadurch elastischer und ergänzend mit einer elastischen Kunststoffschicht überzogen.

Aufgabe der Erfindung ist es, eine elektronische Baugruppe vorzustellen, bei der die Anzahl mechanischer Halterungen reduziert und die Bestückung und Montage der dreidimensionalen Leiterplatten vereinfacht wird.

Die Aufgabe ist durch die kennzeichnenden Merkmale des Patentanspruches 1 gelöst. Vorteilhafte Weiterbildung der Erfindung sind in den Unteransprüchen beschrieben.

Erfinderischer Gedanke ist es, die elektronischen Bauelemente auf mehrere Leiterplattenstücke zu verteilen, diese mit Folienverbindern zu verbinden und um das Bedien- und/oder Aktorelement herum anzuordnen. Um dabei auf zusätzliche mechanische Halterungen verzichten zu können, müssen die Folienverbinder selbst in der Lage sein, die mechanischen Beanspruchungen aufzunehmen. Dazu sind die Folienverbinder trotz ihrer zum Formen der räumlichen Leiterplattenanordnung erforderlichen Elastizität mit einer gewissen Steifigkeit zu versehen. Besonders bevorzugt sind dabei Folienverbinder mit einer Vielzahl von Flachleiterbahnen aus Kupfer mit einer Dicke von 75 bis 150 µm, die durch Polyimidfolien versteift sind.

Zum Schließen und Arretieren der Raumform der Leiterplattenanordnung sind Mittel vorgesehen, vorzugsweise eine mechanisch tragfähige Lötverbindung, die gleichzeitig auch eine elektrische Verbindung realisiert.

Besonders vorteilhaft ist es, zum Herstellen der elektronischen Baugruppe die Leiterplattenstücke zunächst in einer Ebene, also flach, anzuordnen, in dieser Lage mit den elektronischen Bauelementen und Folienverbindern zu bestücken und erst danach die Leiterplattenanordnung entlang der Folienverbinder in die Raumform zu biegen. Dadurch kann die Leiterplattenanordnung besonders einfach bspw. durch einen SMD-Lötprozeß bestückt werden. Die elektronische Baugruppe kann dabei sehr gut an die äußeren Raumform des Bedien- und/oder Aktorelements angepaßt werden, ist dann neben der geringen Platzbedarf auch noch preiswerter als bekannte Lösungen.

Die Erfindung wird nachfolgend anhand von Ausführungsbeispielen und Figuren näher erläutert.

Es zeigen:
- Figur 1: Querschnitt des Leiterplattenverbinders im geraden Zustand,
- Figur 2: Draufsicht auf den Leiterplattenverbinder,
- Figur 3: Querschnitt des Leiterplattenverbinders in Montage mit 90° versetzten Leiterplattenstücken,
- Figur 4: räumliche Anordnung mehrerer Leiterplattenstücke, verbunden mit Leiterplattenverbindern,
- Figur 5: die Anordnung der Leiterplattenstücke in der Ebene zur Bestückung,
- Figur 6: Detailansicht zusätzlicher mechanischer Stützpunkte an den Leiterplattenstücken.
- Figur 7: Einführen des Bedien- und/oder Aktorelements in die räumliche Leiterplattenanordnung
- Figur 8: elektronische Baugruppe, vor dem Verschließen des Gehäuses
- Figur 9: Ansicht auf das freitragend über die Leiterplattenverbinder gehaltene Leiterplattenstück L1 der elektronischen Baugruppe einschließlich der vorderen Gehäusehälfte mit dem elektrischen Anschlußbereich

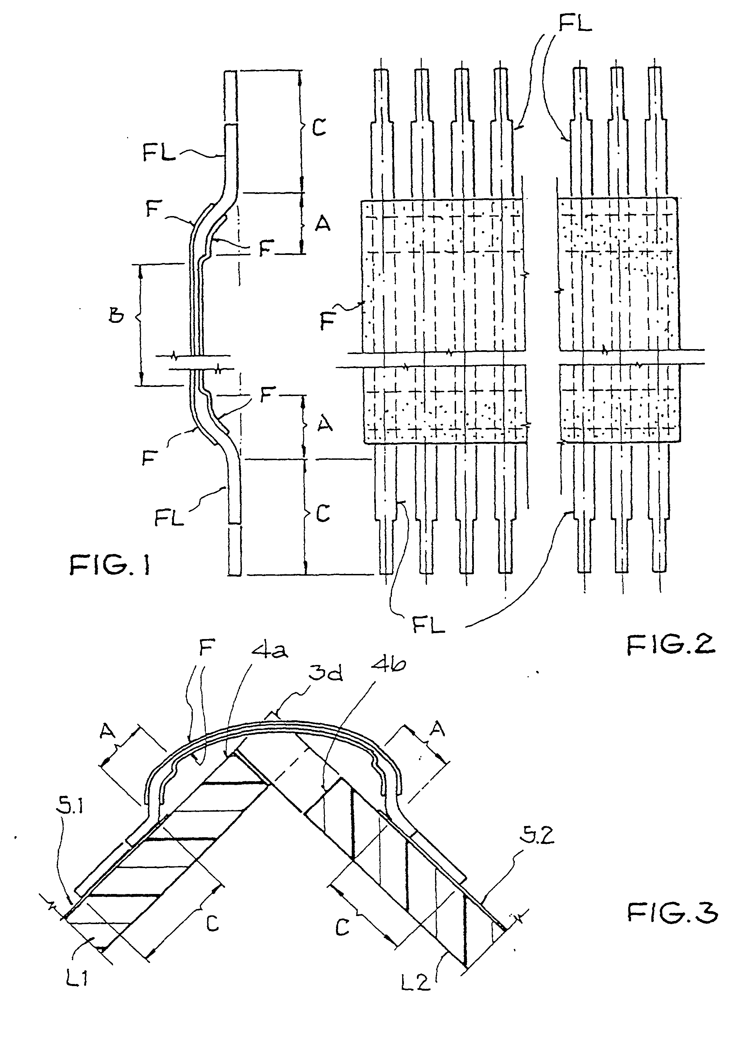

Figur 1 zeigt den Querschnitt eines flexiblen Leiterplattenverbinders. Der Folienverbinder gliedert sich spiegelsymmetrisch in einen Biegebereich B, einen Abstand und den Bereich der Anschlüsse C. In diesem Ausführungsbeispiel sind die Anschlüsse C als SMD-Füsse ausgebildet. Im ungebogenen Zustand weist dazu der Abstand A einen S-förmigen Verlauf auf, der für eine Beabstandung des Biegebereichs von den Leiterplatten erforderlich ist. Im Biegebereich B ist deutlich zu erkennen, daß die Flachleiterbahn FL dünner ausgeführt ist. Oberhalb und Unterhalb des Biegebereichs sowie zumindest Teile des rechten und linken Abstandes A erstreckt eine flexible Folie F, welche mittels Klebstoff an den Flachleiterbahnen befestigt ist.

Figur 2 zeigt eine Draufsicht auf dem Folienverbinder, wobei die Anzahl, der Abstand und die Breite der Flachleiterbahnen FL den konstruktiven Erfordernissen des Einzelfalls angepaßt werden können. In diesem Ausführungsbeispiel ist eine besonders vorteilhafte Weiterbildung der Erfindung zu erkennen, derart daß die SMD-Kontaktfüße eine Verjüngung aufweisen, welche eine bessere Ausbildung des Lötminiskus, und damit eine bessere Röntgenprüftaulichkeit gewährleisten. Die elektrischen Eigenschaften der Flachleiterbahn werden dabei kaum beeinflußt, da in ein Übergangsbereich des Anschlußbereiches C zum Abstand A der volle Querschnitt des Flachleiters FL bereits mit dem Lötmittel in Verbindung kommt.

Figur 3 zeigt einen Querschnitt durch den Leiterplattenverbinder, welcher einerseits die Leiterplattenstücke L1 und L2 elektrisch miteinander verbindet, andererseits eine mechanische Halterung der Leiterplattenstücke darstellt. Der Folienverbinder ist zwischen den Abschnitten A mit der flexiblen Folie F beklebt, die den Biegebereich entlasten. Entscheidend für die konstruktive Ausgestaltung der Erfindung ist das Kräftegleichgewicht zwischen den Biege- und Haftkräften. Wie in Figur 3 zu erkennen, paßt sich der Biegebereich B des flexiblen Leiterplattenverbinders an den 90°-Winkel zwischen den Leiterplattenstücken L1 und L2 an. Um eine möglichst symmetrische Belastung des Biegebereiches B zu erreichen, empfiehlt es sich, die Kontaktbereiche der Leiterplatten mit ihren Leitbahnen bzw. Metallisierungsschichten 5.1 und 5.2 in einem ebenfalls symmetrischen Abstand anzuordnen. Die Anschlußbereiche C sind jeweils entsprechend dem 90°-Winkel der Leiterplatten L1 und L2 ausgerichtet.

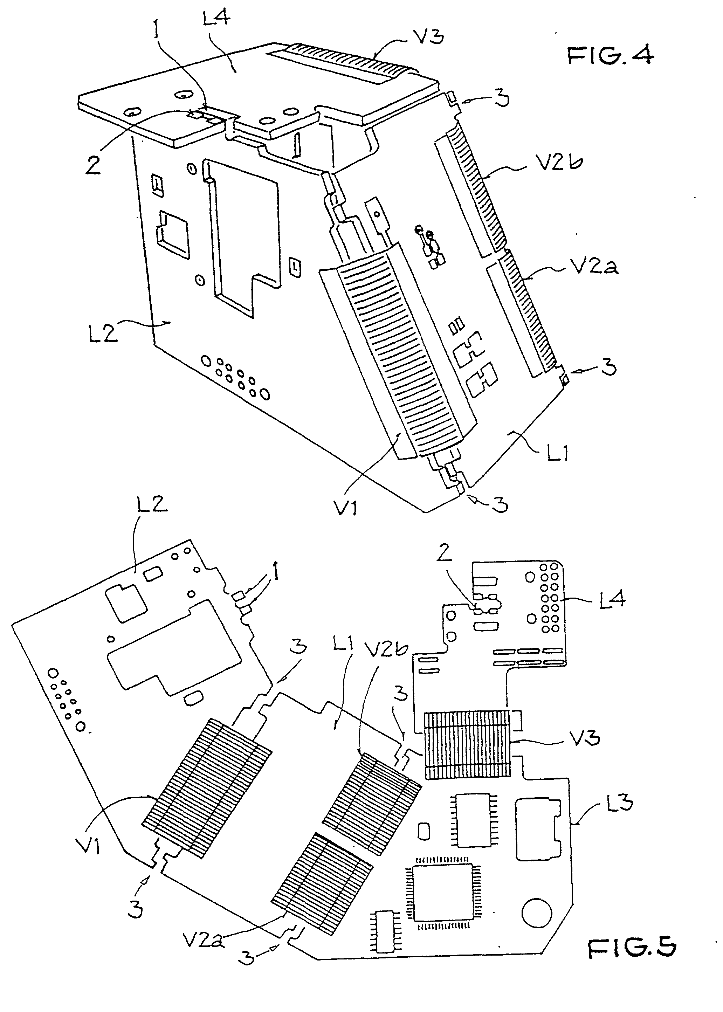

Figur 4 zeigt nun eine räumliche Anordnung mehrerer Leiterplattenstücke L1 bis L4, wobei die Leiterplatte L1 in diesem Ausführungsbeispiel frei von anderen mechanischen Befestigungen nur von den zwei Leiterplattenverbindern V1 und V2 (geteilt in V2a und V2b) gehalten wird. Neben der Verbindung von Leiterplatten mittels Leiterplattenverbinders sind auch Lötverbindungen möglich, wie dies zwischen den Lötstiften 1 und der Lötöffnung 2 zur mechanischen Befestigung der Leiterplattenanordnung in ihrer dreidimensionalen Form benutzt wird. Zur Einsparung von Montagezeit empfiehlt es sich jedoch, möglichst wenig und möglichst große Lötpunkte zu verwenden, beispielsweise die Masseverbindung.

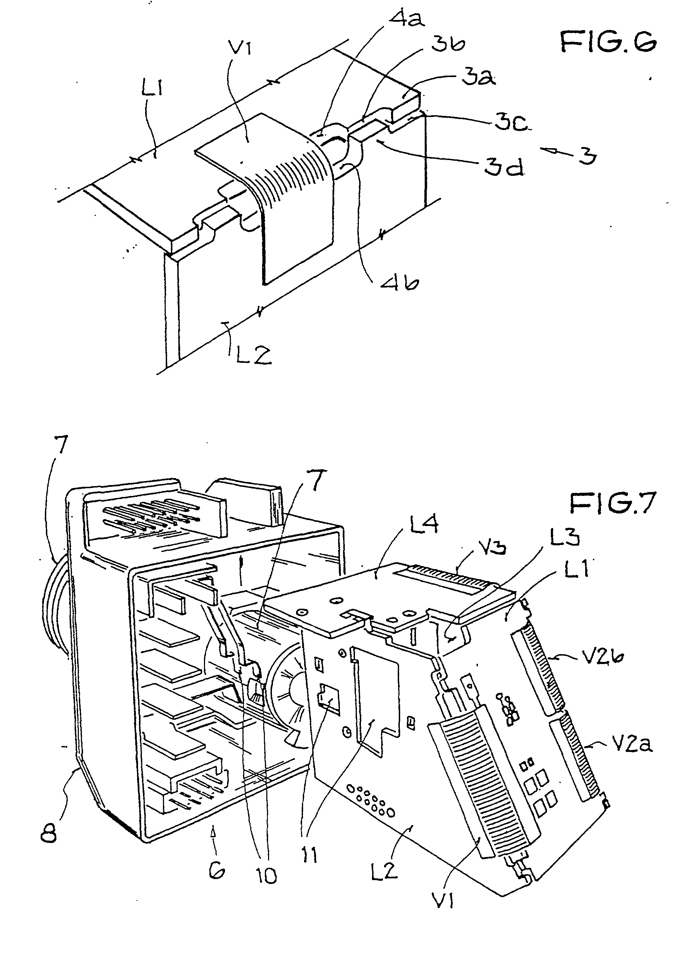

Figur 5 zeigt nun die räumliche Leiterplattenanordnung aus Figur 4 im Bestückungszustand, also während der Bestückung der einzelnen Leiterpfattenstücke. Wie zu erkennen, ist es möglich, alle Leiterplattenstücke L1 bis L4 gleichzeitig und auf einer Ebene mit den Bauelementen und den Folienverbindern V1 bis V3 zu bestücken. Nach Abschluß des Bestückungsprozesses werden die einzelnen Leiterplattenstücke L1 bis L4 zur räumlichen Anordnung gemäß Figur 4 zusammengefaltet. Dabei wird auch der Lötstift 1 in die Lötöffnung 2 eingerastet und verlötet, so daß die räumliche Leiterplattenanordnung gemäß Figur 4 nun in andere Teile eingebaut werden kann. Hervorzuheben ist nochmals, daß das Leiterplattenstück L1 nur von den Leiterplattenverbindern gehalten wird, wobei bei der Bestückung der Leiterplatte LP1 eine entsprechende Gewichtsverteilung der Bauelemente zu berücksichtigen ist.

Die Figuren 4 und 5 zeigen des weiteren bereits die zusätzlichen mechanischen Stützstellen 3, die in Figur 6 vergrößert dargestellt sind. Während in der ebenen Anordnung der Leiterplattenstücke Figur 5 noch zwischen den Stützstellen 3 ein deutlicher Abstand war, ist nun im gebogenen Zustand gemäß Figur 6 zu erkennen, wie die mechanischen Stützstellen ineinander fassen und so die Leiterplatte gegen zu große Belastungen schützen. Die mechanischen Stützstellen bestehen aus einem ersten Vorsprung 3a an dem ersten Leiterplattenstück L1, dem eine Einbuchtung 3c an der zweiten Leiterplattenstück L2 zugeordnet ist und einem zweiten Vorsprung 3d nun an dem zweiten Leiterplattenstück L2 und einer zugehörigen Einbuchtung 3b am ersten Leiterplattenstück L1.

Es ist auch denkbar, diese mechanischen Stützstellen zu metalllisieren und dann nach dem Biegen in die dreidimensionale Anordnung Lötverbindungen, beispielsweise an der Massenverbindung der Leiterplatten, über diese Punkte zu realisieren.

In Figur 7 wird das Einführen des Bedien- und/oder Aktorelements 7 in die räumliche Leiterplattenanordnung (vgl. Fig. 4) visualisiert. Das Bedienund/oder Aktorelement 7 ist in diesem Ausführungsbeispiel ein elektronisches Zündschloß für Kraftfahrzeuge ; der erfinderische Gedanke jedoch nicht darauf begrenzt. Das Bedien- und/oder Aktorelement 7 ist in der vorderen Gehäusehälfte 8 angeordnet, die einen elektrischen Anschlußbereich 6 sowie Verbindungsmittel 10 zum mechanischen und/oder elektrischen Verbinden der räumlichen Leiterplattenanordnung mit dem Bedien- und/oder Aktorelement 7 und der vorderen Gehäusehälfte 8 aufweist. An dem Leiterplattenstück L2 sind auch die Öffnungen 11 angedeutet, in die die Verbindungsmittel 10 eingreifen und einratsen bzw. den elektrischen kontakt herstellen.

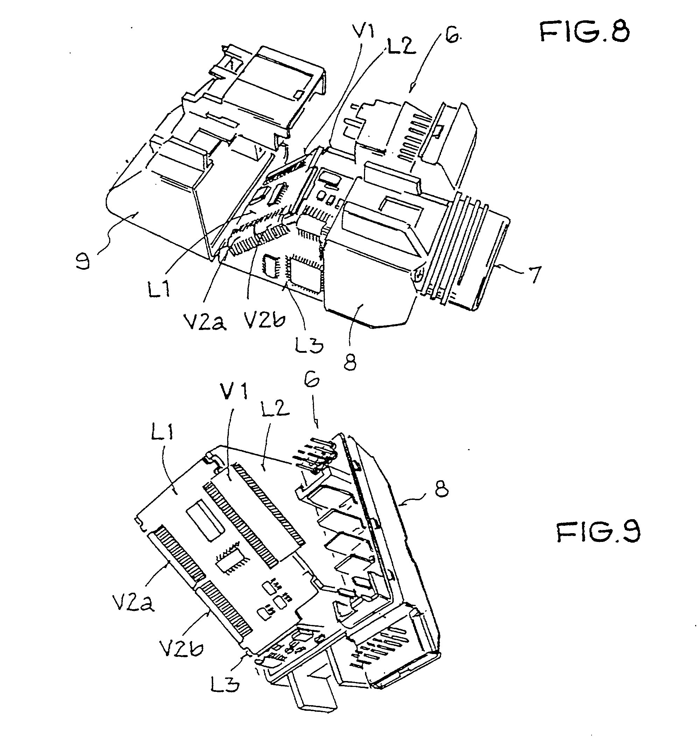

Die Figur 8 zeigt nun die elektronische Baugruppe vor dem Verschließen des Gehäuses, bestehend aus einer vorderen Gehäusehälfte 8 mit einem elektrischen Anschlußbereich 6 und einem hinteren Gehäuseteil 9, welcher Öffnungen zum Durchführen des Anschlußbereichs 6 aufweist. Am vorderen Gehäuseteil ist außerdem die Abdeckung für das Bedien- oder Aktorelement 7 zu erkennen, welches sich im Inneren des von den Leiterplattenstücken gebildeten Raumes befindet.

Figur 9 zeigt noch einmal in einer gegenüber der Figur 8 gedrehten Lage die elektronische Baugruppe. Bei dieser Ansicht wird nochmals das freitragend über die Leiterplattenverbinder V1 und V2a,V2b gehaltene Leiterplattenstück L1 der elektronischen Baugruppe einschließlich der vorderen Gehäusehälfte 8 mit dem elektrischen Anschlußbereich 6 deutlich erkennbar.

## Patentansprüche

1. Elektronische Baugruppe, bestehend aus:
einem Bedien- und/oder Aktorelement (7),
einer räumlichen Leiterplattenanordnung aus mehreren mit elektronischen Bauelementen bestückten Leiterplattenstücken (L1,L2,L3,L4), wobei
die Leiterplattenstücke (L1,L2,L3,L4) über Folienverbinder (V1,V2a,V2b,V3) miteinander elektrisch verbunden sind und
an den Folienverbindem (V1,V2a,V2b,V3) in eine an die Raumform des Bedienund/oder Aktorelements (7) angepasste räumliche Anordnung gebogen sind, so dass das Bedien- und/oder Aktorelement (7) teilweise von den Leiterplattenstücken (L1,L2,L3,L4) umschlossen wird,
Mittel zum Verbinden (10) der Leiterplattenanordnung mit dem Bedien- und/oder Aktorelement
und Mitteln zum Schließen (1,2) und Arretieren der Leiterplattenanordnung in der Raumform,
wobei die Folienverbinder (V1,V2a,V2b,V3) einerseits eine zum Biegen in die Raumform notwendige Elastizität und andererseits eine derartige Steifigkeit besitzen, so dass zumindest einzelne Leiterplattenstücke (L1) anhand der Folienverbinder (V1, V2a,V2b) freitragend lagestabil befestigt sind.

2. Elektronische Baugruppe gemäß Patentanspruch 1, wobei die Folienverbinder (V1,V2a,V2b,V3) eine Vielzahl parallel zueinander angeordneter Flachleiterbahnen (FL) aus Kupfer mit einer Dicke im Biegebereich zwischen 75 und 150 µm aufweisen und auf die Ober- und/oder Unterseite Polyamidfolie einer Dicke um ca. 25 µm aufgeklebt ist.

3. Elektronische Baugruppe gemäß Patentanspruch 1 oder 2, wobei die Mittel (1,2) zum Schließen und Arretieren der Leiterplattenanordnung zwischen zwei Leiterplattenstücken (L2,L4) vorgesehen sind und aus einer Lötöffnung (2) in einem Leiterplattenstück (L4) und einem darin verlötbaren Teil (1) an einem benachbarten Leiterplattenstück (L2) besteht.

4. Elektronische Baugruppe gemäß Patentanspruch 1, wobei die Lötöffnung (2) und das darin verlötbare Teil (1) gleichzeitig auch eine elektrische Verbindung zwischen den Leiterplattenstücken (L2,L4) schaffen.

5. Verfahren zum Herstellen der elektronischen Baugruppe nach einem der vorangehenden Ansprüche, wobei,
die Leiterplattenstücke (L1,L2,L3,L4) in einer Ebene angeordnet und so mit den Folienverbindern (V1,V2a,V2b,V3) und den elektrischen Bauelementen bestückt werden und
die Leiterplattenanordnung anschließend an den Folienverbindern (V1,V2a,V2b,V3) um das Bedien- und/oder Aktorelement (7) gefaltet, arretiert und mit dem Bedien- und Aktorelement (7) verbunden wird.

6. Verwendung einer elektronischen Baugruppe nach einem der vorangehenden Ansprüche als elektronisches Zündschloss für Kraftfahrzeuge.

## Claims

1. Electronic module, consisting of:
an operating and/or actuator element (7),
a three-dimensional printed circuit board arrangement of a plurality of printed circuit board pieces (L1, L2, L3, L4) which are equipped with electronic components, wherein the printed circuit board pieces (L1, L2, L3, L4) are electrically connected together by means of foil connectors (V1, V2a, V2b, V3) and
bent at the foil connectors (V1, V2a, V2b, V3) into a three-dimensional arrangement which is adapted to the three-dimensional form of the operating and/or actuator element (7), so that the operating and/or actuator element (7) is partly enclosed by the printed circuit board pieces (L1, L2, L3, L4),
means for connecting (10) the printed circuit board arrangement to the operating and/or actuator element
and means for closing (1, 2) and locking the printed circuit board arrangement in the three-dimensional form,
wherein the foil connectors (V1, V2a, V2b, V3) are on the one hand of an elasticity which is necessary for bending into the three-dimensional form and on the other of a stiffness such that at least individual printed circuit board pieces (L1) are secured in self-supporting fashion and in a stable position by means of the foil connectors (V1, V2a, V2b).

2. Electronic module according to Claim 1, wherein the foil connectors (V1, V2a, V2b, V3) comprise a multiplicity of flat conductor tracks (FL) of copper which are disposed parallel to one another and are of a thickness in the bending region of between 75 and 150 µm, and a polyamide film of a thickness of approximately 25 µm is adhered onto the top side and/or underside.

3. Electronic module according to Claim 1 or 2, wherein the means (1, 2) for closing and locking the printed circuit board arrangement are provided between two printed circuit board pieces (L2, L4) and consist of a soldering opening (2) in a printed circuit board piece (L4) and a part (1), which can be soldered therein, on an adjacent printed circuit board piece (L2).

4. Electronic module according to Claim 1, wherein the soldering opening (2) and the part (1) which can be soldered therein at the same time also establish an electrical connection between the printed circuit board pieces (L2, L4).

5. Method for producing the electronic module according to any one of the preceding Claims, wherein
the printed circuit board pieces (L2, L2, L3, L4) are disposed in one plane and thus equipped with the foil connectors (V1, V2a, V2b, V3) and the electrical components and
the printed circuit board arrangement is then folded at the foil connectors (V1, V2a, V2b, V3) about the operating and/or actuator element (7), locked and connected to the operating and actuator element (7).

6. Use of an.electronic module according to any one of the preceding Claims as an electronic ignition lock for motor vehicles.

## Revendications

1. Ensemble électronique se composant:
d'un élément de service et/ou de manoeuvre (7),
d'une disposition spatiale de plaquettes de circuit imprimé comprenant plusieurs éléments de plaquette de circuit imprimé (L1, L2, L3, L4) garnis de composants électroniques,
les éléments de plaquette de circuit imprimé (L1, L2, L3, L4) étant réunis électriquement par l'intermédiaire de connecteurs sous forme de feuilles (V1, V2a, V2b, V3) et
les connecteurs sous forme de feuilles (V1, V2a, V2b, V3) sont courbés en une disposition spatiale adaptée à la forme spatiale de l'élément de service et/ou de manoeuvre (7), de sorte que l'élément de service et/ou de manoeuvre (7) est entouré partiellement par les éléments de plaquette de circuit imprimé (L1, L2, L3, L4),
de moyens en vue de la liaison (10) de la disposition de plaquettes de circuit imprimé avec l'élément de service et/ou de manoeuvre
et de moyens de fermeture (1,2) et de blocage de la disposition de plaquettes de circuit imprimé selon la forme spatiale,
les connecteurs sous forme de feuilles (V1, V2a, V2b, V3) possédant d'une part une élasticité nécessaire en vue de la flexion selon la forme spatiale et d'autre part une rigidité de telle sorte qu'au moins différents éléments de plaquettes de circuit imprimé (L1) soient fixés stables en position de façon autonome à l'aide des connecteurs sous forme de feuilles (V1, V2a, V2b).

2. Ensemble électronique selon la revendication 1, dans lequel les connecteurs sous forme de feuilles (V1, V2a, V2b, V3) présentent une pluralité de pistes conductrices parallèles entre elles (FL) en cuivre d'une épaisseur dans la zone de flexion entre 75 et 150 µm et sur le côté supérieur et/ou inférieur est collée une feuille de polyamide d'une épaisseur d'environ 25 µm.

3. Ensemble électronique selon la revendication 1 ou 2, dans lequel les moyens (1, 2) de fermeture et de blocage de la disposition de plaquettes de circuit imprimé sont prévus entre deux éléments de plaquettes de circuit imprimé (L2, L4) et se composent d'une ouverture de soudage (2) dans un élément de plaquette de circuit imprimé (L4) et d'une partie (1)) pouvant être soudée à celle-ci sur un élément de plaquette de circuit imprimé adjacent (L2°;

4. Ensemble électronique selon la revendication 1, dans lequel l'ouverture de soudage (2) et la partie (1) pouvant être soudée à celle-ci constituent simultanément également une liaison électrique entre les éléments de plaquettes de circuit imprimé (L2, L4).

5. Procédé de fabrication de l'ensemble électronique selon une des revendications précédentes, dans lequel les éléments de plaquette de circuit imprimé (L1, L2, L3, L4) sont disposés dans un plan et ainsi sont garnis des connecteurs sous forme de feuilles (V1, V2a, V2b, V3) et des composants électroniques et
la disposition de plaquettes de circuit imprimé est ensuite pliée sur les connecteurs sous forme de feuilles (V1, V2a, V2b, V3)) autour de l'élément de service et/ou de manoeuvre (7), bloquée et reliée à l'élément de service et/ou de manoeuvre (7).

6. Utilisation d'un ensemble électronique selon une des revendications précédentes en tant qu'antivol électronique pour véhicules.
